# EUROPEAN PATENT SPECIFICATION

(11) **EP 1 409 757 B1**
(45) Date of publication and mention of the grant of the patent: **25.03.2015**
(21) Application number: 02735894.4
(22) Date of filing: 21.06.2002
(51) Int. Cl.: C22C 29/08, C22C 1/05

(54) **FINE GRAINED SINTERED CEMENTED CARBIDE, PROCESS FOR MANUFACTURING AND USE THEREOF**
FEINKÖRNIGER SINTERKARBIDKÖRPER SOWIE DESSEN HERSTELLUNGSVERFAHREN UND VERWENDUNG
CARBURE CEMENTE FRITTE A GRAINS FINS, PROCEDE DE FABRICATION ET UTILISATION

(30) Priority: 23.07.2001 DE 10135790
(43) Date of publication of application: 21.04.2004
(73) Proprietor: KENNAMETAL INC., Latrobe, PA 15650 (US)
(72) Inventor: HEINRICH, Hans-Wilm, 95445 Bayreuth (DE); SCHMIDT, Dieter, 95445 Bayreuth (DE); WOLF, Manfred, 95488 Eckersdorf (DE)
(74) Representative: Prinz & Partner mbB
(86) International application number: PCT/IB2002/002384
(87) International publication number: WO 2003/010350

(56) References cited:
- EP-A- 1 054 071
- FR-A- 743 472
- GB-A- 1 085 041
- US-A- 6 027 808
- US-B1- 6 254 658
- PATENT ABSTRACTS OF JAPAN vol. 1997, no. 08, 29 August 1997 (1997-08-29) -& JP 09 111391 A (HITACHI TOOL ENG LTD), 28 April 1997 (1997-04-28)
- PATENT ABSTRACTS OF JAPAN vol. 013, no. 241 (C-604), 6 June 1989 (1989-06-06) -& JP 01 052043 A (NACHI FUJIKOSHI CORP), 28 February 1989 (1989-02-28)

## Description

The invention relates to a fine grained sintered cemented carbide containing chromium, consisting of a first phase based on tungsten carbide (WC) which is bound by means of a second phase of a metallic binder based on Co or CoNiFe, and of at least one additional phase comprising at least one carbide or mixed carbide of tantalum.

Polyphase cemented carbides of this type have been known for a long time, the cemented carbide grades being distinguished according to the compromise between physical properties selected to vary depending on the particular intended use (hardness, bending strength, pressure resistance, modulus of elasticity). Accordingly, the cemented carbides are classified according to the international standard ISO/Tc29 into the P, M and K grades suitable for metal cutting purposes and the G grades preferably used for non-cutting shaping and parts subject to wear, which have different binder metal contents and different additional carbide contents, in addition to tungsten carbide as the main constituent. The harder a cemented carbide grade, the better its wear resistance, but the worse its bending strength.

In cemented carbides for metal cutting purposes, the quality of a cemented carbide grade is dictated quite substantially by its high-temperature properties. The hardness of the cemented carbides is in some cases reduced dramatically as temperature rises, while noxious scaling and diffusion processes increase at the same time, and the deformation behavior of cutting inserts or other bodies made from the cemented carbide likewise changes drastically.

A simple WC-Co cemented carbide having a cobalt content of about 10 %, for example, will feature only about one third of its hardness at 800°C compared with its hardness at room temperature, whereas a P10 cemented carbide containing additions of TiC and (Ta, Nb)C will still feature about half of its hardness compared with that at room temperature.

Finally, the mechanical properties of the sintered cemented carbides are affected by the way of their powder-metallurgical manufacture. Grain growth is almost impossible to avoid during sintering and hot isostatic pressing (HIPping) of the corresponding green compacts and has a negative effect on the bending strength of the sintered cemented carbide. Therefore, specific carbides are admixed to the starting powder blend as grain growth inhibitors. The most frequently used grain growth inhibitors are carbides of tantalum, chromium and vanadium, with tantalum carbide being usually employed as (Ta, Nb)C mixed carbide, owing to the natural association of the metals tantalum and niobium and for reasons of cost. The effectiveness of the three aforementioned commonly used grain growth inhibitors increases in the order mentioned, from Ta via Cr to V.

The complexity of the process sequences in cemented carbide manufacturing is still further increased in that both tungsten from the tungsten carbide and the metals of the grain growth inhibitors diffuse into the binder phase and dissolve therein to form a solid solution. Since the solubility of these metals in the binder metal is of course higher at higher temperatures than at room temperature, the solubility, that is, the maximum dissolved concentration at a particular temperature, can be exceeded, whereby the excessive amount which is no longer soluble precipitates out of the binder phase again or is deposited on the surface of the WC grains. Such deposition, however, impairs the wetting of the grains with the binder metal, which in turn results in a deterioration in the bending strength. A person of ordinary skill in the art thus has been and still is aware that only very small amounts of grain growth inhibitors should be utilized so as to achieve as good a compromise as possible between a prevention of grain growth during sintering and a deterioration of the wetting of the WC grains with binder metal.

Another technique at first suggesting itself for counteracting grain growth consisted in using finer starting powders from the outset, i.e. the use of fine (0.8 to 1.3 µm), submicron (0.5 to 0.8 µm), ultrafine (0.2 to 0.5 µm) or even nano particles (< 0.2 µm), rather than coarse (2.5 to 6.0 µm) or medium coarse particles (1.3 to 2.5 µm), for the manufacture of the starting powder blend, even though the powders become more expensive as they increase in fineness, causing additional difficulties in handling and in producing the green compacts. Use of finer starting particles would obviate part of the grain growth inhibitors. This path was followed, in different ways, by U.S. Patent 5,918,102 and German Patent 40 00 223.

According to U.S. Patent 5,918,102 a powder blend of ultrafine WC and 6 to 15 wt.% binder metal is used, which is mixed with up to about 1 wt.% of grain growth inhibitors in the form of one or more of the carbides TiC, TaC, NbC, HfC, ZrC, Mo₂C and VC.

German Patent 40 00 223 describes a microdrill made from a cemented carbide based on WC and Co, which is intended for producing submicron size holes in circuit boards and is manufactured from submicron tungsten carbide powder having an average particle size of 0.6 µm and having added thereto 4 to 10 wt.% (Cr + V), as related to the total weight of the binder alloy based on cobalt, because the authors of this printed publication have found that the grain growth of tungsten carbide can be more effectively prevented by the addition of such an amount of V and Cr than by an addition of tantalum carbide.

US 6,027,808 A describes a cemented carbide for a drill, the base material of which consists of WC bound by means of an iron-group metal and at least one grain growth inhibitor chosen from the group of V, Cr, Ta and Mo, either as a carbide or in solid solution and in an amount of 0.1 to 3 wt.%. Example E of Table 1 shows a composition consisting of 5.0 wt.% cobalt, 0.5 wt.% of chromium carbide and 0.3 wt.% of tantalum carbide, the balance being tungsten carbide.

JP 01 052 043 A discloses fine grained sintered cemented carbides for metal cutting, comprising 3 to 30 wt.% cobalt and / or nickel, 0.2 to 0.8 % chromium, 0.4 to 1.8 % of one or more of Ta, (Ta, Nb)C and / or V and the balance tungsten carbide. Specific examples show compositions consisting of 10 wt.% cobalt, 5 wt.% nickel, 0.6 wt.% chromium, 0.5 wt.% vanadium, 0.5 wt.% tantalum, 0.3 wt.% (Ta, Nb)C, and the balance tungsten carbide (Example 8), or 15 wt.% cobalt, 0.6 wt.% chromium, 0.5 wt.% vanadium, 0.5 wt.% tantalum, 0.3 wt.% (Ta, Nb)C, rest WC (Example 10).

EP 1 054 071 A2 generally teaches the use of grain growth inhibitors comprising chromium carbide or combinations of vanadium carbide and chromium carbide, or other cubic carbides in groups IV and V of the periodic table such as titanium carbide, zirconium carbide, hafnium carbide, vanadium carbide, niobium carbide, tantalum carbide, or the hexagonal Mo₂C of group VI.

It turned out, however, that the cemented carbide grades mentioned in the two patents are not so suitable for metal cutting purposes, in particular for the cutting of steel, because they do not have the necessary high temperature properties (high temperature hardness, resistance to scaling and diffusion, wear characteristics in the cutting test).

The object of the invention is therefore to provide novel, fine grained and at the same time corrosion-resistant sintered cemented carbide grades having improved high temperature properties, in particular having improved wear characteristics in the metal cutting test, which may be employed for all kinds of metal cutting purposes and used in particular for the manufacture of cutting inserts and other cutting tools, but also for the manufacture of heavily stressed parts subject to wear, such as, e.g., rollers.

This object is achieved in accordance with the invention by a fine grained sintered cemented carbide containing chromium, as claimed in claim 1.

The applicants have surprisingly succeeded in providing, for the first time, a fine grained sintered cemented carbide containing chromium, in which a good trade-off between hardness and bending strength is attained by an effective suppression or restriction of grain growth, on the one hand by the addition of a grain growth inhibitor known per se, namely TaC or (Ta,Nb)C, and on the other hand by the use of a fine, submicron and/or ultrafine tungsten carbide powder, and in which furthermore the solubility of the tantalum in the binder phase at room temperature is exceeded by the addition of tantalum in relatively large amounts of up to approximately 4 mass-% in the presence of chromium at the same time, so that an additional phase precipitates which comprises a TaC phase visible in the sintered cemented carbide by optical microscopy. The saturation of the binder phase with Ta and the simultaneous presence of chromium in the solid solution of the binder phase, and the precipitation of the additional TaC phase in the form of a discrete phase visible by optical microscopy, improve the deformation behavior, the resistance to scaling and diffusion and, above all, the high temperature properties of the cemented carbide in accordance with the invention and the shaped bodies produced therefrom to such an extent that, unlike the grades disclosed in German Patent 40 00 223 and U.S. Patent 5,918,102, the cemented carbide grades in accordance with the invention may even and in particular be utilized for metal cutting purposes where extremely high temperatures and heavy thermal shock stresses can occur. This considerably broadens the previously known ranges of application of submicron and ultrafine sintered cemented carbides in the field of metal cutting, something which is totally surprising among expert circles in view of the prior art.

In the process in accordance with claim 18 for manufacturing the sintered cemented carbide, preferably in the form of a three-dimensional body, for instance a cutting insert, fine, powdery starting materials including WC as a main constituent, Co or CoNiFe as a binder and compounds of Cr and Ta as well as, optionally, V and/or Nb, are ground in a ball mill or an attrition mill with the addition of carbon or tungsten and conventional grinding and/or sintering aids, compressed to form a green compact of the desired shape, and subsequently sintered and, optionally, provided with a hard, wear-resistant coating, wherein only submicron and ultrafine tungsten carbide grades having grain sizes of between 0.1 and 0.8 µm are used, and wherein Cr and Ta and, optionally, V and/or Nb are added to the powder blend in amounts so as to exceed the solubility of these metals in the binder phase at room temperature.

The solubility of the tantalum in the binder phase at room temperature is already exceeded at 0.3 %, as related to the total mass of the sintered cemented carbide. From this results the lower limit of the claimed tantalum content. The upper limit of 4 % tantalum should not be exceeded because otherwise there is the risk of structural changes occurring in the sintered cemented carbide which can again impair the good high temperature properties of the sintered cemented carbide.

The best results could be achieved with a tantalum content of 0.8 to 1.2 %, as related to the total mass of the sintered cemented carbide.

In order to reduce costs it is advantageous to use a tantalum in which up to 50 mass-% are replaced by niobium. In this case the binder phase based on Co or CoNiFe contains not only tantalum, aside from the metals W and Cr, but also niobium dissolved in solid solution, and the at least one additional phase then further comprises a (Ta, Nb)C phase visible by optical microscopy, in addition to the TaC phase. Accordingly, the sintered cemented carbide in accordance with the invention may contain up to 2 % Nb, preferably 0.4 to 0.6 % Nb, as related to the total mass of the sintered cemented carbide.

According to the invention, the WC grains in the sintered cemented carbide have a grain size of between 0.1 and 1.3 µm, preferably between 0.3 and 0.6 µm. Up to 3 mass-% of the tungsten carbide may be replaced by at least one hard component which is selected from the carbides, nitrides, carbonitrides, including their mixtures and solid solutions, of the metals titanium, zirconium, hafnium and molybdenum.

For manufacturing the sintered cemented carbides in accordance with the invention, it is also possible to advantageously use such commercially available WC grades which are doped with one or more grain growth inhibitors, such as with chromium carbide (Cr₃C₂) and/or with vanadium carbide (VC), for example. The use of such WC grades which contain up to 0.6 wt.% Cr₃C₂ and/or up to 0.4 wt.% VC is particularly preferred.

In the sintered cemented carbide in accordance with the invention the binder phase preferably accounts for 3 to 18 % of the total mass of the sintered cemented carbide. A content above 18 % will be at the expense of the hardness and a content below 3 % will cause a decrease in the bending strength of the sintered cemented carbide.

The binder phase may contain up to 20 % tungsten, as related to its mass and dissolved in solid solution. The chromium content of the sintered cemented carbide amounts to 1 to 30 %, as related to the total mass of the binder phase. According to the invention, the chromium content either is in the range of 1 to 12 %, preferably 6 to 12 %, or in the range of 17 to 30 %, each as related to the total mass of the binder phase. If the chromium content is within the window of approximately 6 to 12 %, no additional (Cr, Co)-rich mixed carbide phase will form in the sintered cemented carbide according to the invention, whereas on the other hand, if the chromium content is within the window between 17 and 30 %, an additional (Cr, Co)-rich mixed carbide phase will form, with the fracture toughness values being high within both of the chromium content windows. Surprisingly, the bending strength drops sharply in the range in between, above 12 % and below 17 % chromium, for reasons lacking an explanation to date. The high temperature properties of the sintered cemented carbide, however, are better over the entire range than those of the known fine to ultrafine sintered cemented carbides.

One particularly preferred embodiment of the sintered cemented carbide in accordance with the invention additionally contains up to 8 % vanadium, as related to the total mass of the binder phase, more particularly preferred at least 2 % V. In this case the binder phase additionally contains vanadium dissolved in the solid solution consisting of cobalt and the other aforementioned metals or of CoNiFe and the aforesaid metals.

When the solubility of vanadium in the binder phase at room temperature is exceeded, further phases precipitate which are visible by optical microscopy: the at least one additional phase will then comprise at least one of the phases (Ta, V)C and (Ta, Nb, V)C.

According to the invention, it is basically preferred here that the metals dissolved in the binder phase, with the exception of tungsten, are dissolved in the binder phase in an amount corresponding to their respective solubility in the binder phase at room temperature, that is, to their respective maximum concentration under the given circumstances and at room temperature. Only the percentage of the tungsten dissolved in the binder phase is preferably limited to a maximum of 20 %, as related to the total mass of the binder phase.

The porosity of the sintered cemented carbide in accordance with the invention is preferably below the A 02 degree.

The sintered cemented carbide in accordance with the invention is preferably provided with a hard, wear-resistant coating which is applied by physical or chemical vapor deposition (PVD or CVD) and, as with known sintered cemented carbide grades, usually consists of one or more layers of TiC, TiN, TiCN, TiAlN and/or Al₂O₃. for example.

In the manufacture of the sintered cemented carbides according to the invention the metals chromium and tantalum and, optionally, vanadium and/or niobium are added to the starting powder blend preferably individually or in solid solution in the form of carbides and/or oxides.

The amount of carbon or tungsten to be added to the starting powder blend is known and familiar to those skilled in the present field since the product of W and C in the cobalt-rich mixed crystal of the binder phase always remains constant. The amounts to be added are to be selected so as to form neither a brittle η-phase nor free carbon.

The cemented carbide in accordance with the invention is preferably employed for the production therefrom of cutting tools comprising a rake face and a flank face and comprising a cutting edge at the intersection of the rake face and the flank face, particularly preferably in the form of a drill, a bit, a milling cutter or a part of such tools, or in the form of a cutting insert or an indexable insert. But the sintered cemented carbide grades in accordance with the invention can also be used to particular advantage for the manufacture of tools for non-cutting shaping and parts subject to wear, such as rollers and cylinders.

Accordingly, the invention comprises, inter alia, the following embodiments of a fine grained sintered cemented carbide containing chromium and tantalum:

### Group I

Hard component combination employed: WC+Cr₃C₂+TaC
Binder phase: W+Cr+Ta, dissolved in Co or in CoNiFe, with Ta and Cr being dissolved up to their respective limit of solubility at room temperature
Additional phase visible by optical microscopy: TaC

### Group II

Hard component combination employed: WC+Cr₃C₂+(Ta, Nb)C or TaC + NbC
Binder phase: W+Cr+Ta+Nb, dissolved in Co or CoNiFe, with Ta, Nb and Cr being dissolved up to their respective limit of solubility at room temperature
Additional phase visible by optical microscopy: TaC+(Ta, Nb)C

### Group III

Hard component combination employed: WC+Cr₃C₂+TaC+VC
Binder phase: W+Cr+Ta+V, dissolved in Co or CoNiFe, with Ta, Cr and V being dissolved up to their respective limit of solubility at room temperature
Additional phase visible by optical microscopy: TaC+(Ta, V)C

### Group IV

Hard component combination employed: WC+Cr₃C₂+VC+(Ta, Nb)C or TaC + NbC
Binder phase: W+Cr+Ta+Nb+V, dissolved in Co or CoNiFe, with Ta, Nb, Cr and V each being dissolved up to their limit of solubility at room temperature
Additional phase visible by optical microscopy: TaC+ (Ta, V)C+(Ta, Nb, V)C

### Groups V through VIII

As with Groups I through IV, but each comprising a further additional phase of (Cr, Co)-rich MₓC_{y} carbides visible by optical microscopy

### Groups IX through XVI

As with Groups I through VIII, but comprising an additional content of up to 3 mass-%, as related to the mass of the tungsten carbide, of at least one hard component which is selected from the carbides, nitrides, carbonitrides, including their mixtures and solid solutions, of the metals Ti, Zr, Hf and Mo.

The grain sizes and quantitative ratios as indicated in the claims apply to all of these embodiments.

The invention will be explained in greater detail below with reference to micrographs, charts and embodiments:

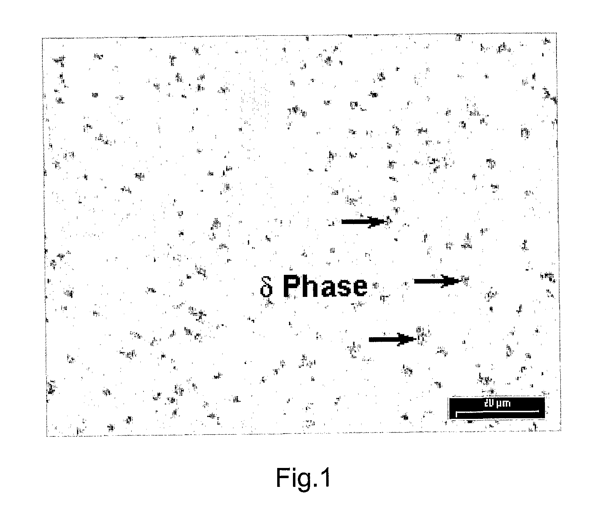

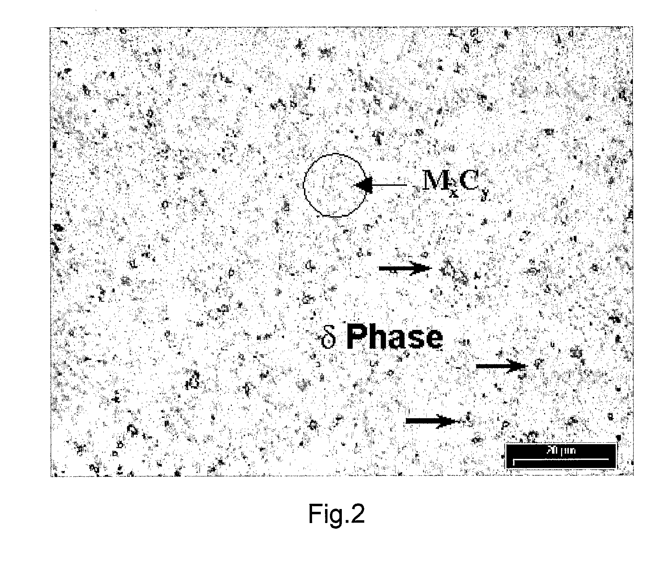

Figures 1 and 2 are photographs of optical microscopy magnifications (200 times) of etched microsections of embodiments of the sintered cemented carbide in accordance with the invention, which show the formation of at least one additional phase of (Ta, V)C and/or (Ta, Nb, V)C, visible by optical microscopy, termed "δ-phase" here, and the uniform distribution thereof over the cross-section of the sintered cemented carbide.
   In addition to the δ-phase, the development of a phase of (Cr, Co)-rich mixed carbides of the general formula MₓC_{y} can be best seen in Figure 2.

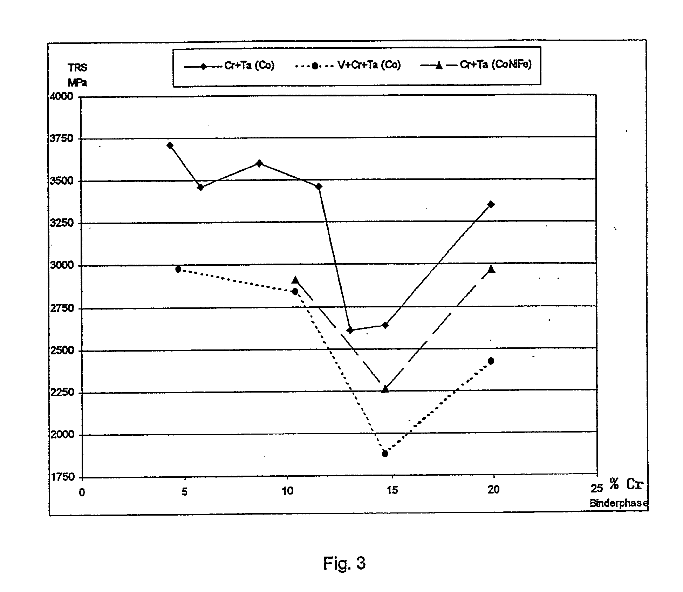

Figure 3 is a chart showing the bending strength (TRS), measured in MPa (ordinate), of the sintered cemented carbide, as plotted against the chromium content of the binder phase, given in mass-% (abscissa), for three different sintered cemented carbide grades in accordance with the invention, having differing binder phases, namely, (1) Cr+Ta dissolved in Co up to their limit of solubility at room temperature, (2) V+Cr+Ta dissolved in Co up to their limit of solubility at room temperature, and (3) Cr+Ta dissolved in CoNiFe up to their limit of solubility at room temperature.

The astonishing profiles of the three graphs of Figure 3 reveal that a chromium content of between approximately 12 and 17 mass-% results in bending strengths which are significantly lower than the bending strengths both for chromium contents of < 12 % and also for chromium contents of > 17 %. Proceeding from the limits of the aforecited window, the bending strengths surprisingly rise sharply in both directions, both in the direction of lower chromium contents and in the direction of higher chromium contents.

Although the binder alloys which, besides the binder metal cobalt or CoNiFe, contain only chromium and tantalum, and the binder alloy which additionally contains vanadium in solid solution (with up to 50 mass-% of the tantalum being replaceable by niobium in all cases), in principle behave similarly when there is a change in the chromium content, Figure 3 directly teaches that the binder phase containing vanadium is at a distinctly lower level with regard to the values attained for the bending strength. For this reason, according to the invention chromium contents of ≥ 17 mass-% are preferred for those cemented carbide grades in accordance with the invention which, aside from chromium, only contain tantalum and, optionally, niobium, whereas chromium contents of ≤ 12 mass-% are preferred for those cemented carbide grades which, in addition to chromium, contain tantalum and vanadium and, optionally, niobium. The presence of an additional (Cr, Co)-rich mixed carbide phase MₓC_{y}, as can be seen in Figure 2, or the absence of such (Cr, Co)-rich mixed carbide phase MₓC_{y}, as can be seen in Figure 1, appears to have no impact on the profiles of the TRS/chromium content curves, irrespective of whether or not the sintered cemented carbide additionally contains vanadium.

Finally, it has been found that the cemented carbide grades in accordance with the invention which do not contain vanadium, reach their maximum hardness values with chromium contents of more than 13 mass-%, while cemented carbide grades which in addition contain vanadium reach their maximum hardness values with chromium contents of less than 8 mass-%.

For manufacturing the sintered cemented carbides in accordance with the invention the powdery raw materials as specified below were used.

| Raw material | Manufacturer | Average grain size |
|---|---|---|
| Co | OMG | 1.3 µm |
| VC | H.C. Starck | 1.3 µm |
| Cr₃C₂ | H.C. Starck | 1.5 µm |
| Ta₂O₅ | H.C. Starck | <1.0 µm |
| TaC | Kennametal | 1.2 µm |
| (Ta,Nb)C | Kennametal | 1.2 µm |
| WC¹ | H.C. Starck | 0.4 µm |
| WC² | H.C. Starck | 0.4 µm |
| WC³ | WBH | 0.6 µm |
| WC⁴ | Dow Chemical | 0.8 µm |
| WC¹: doped with 0.4 wt.% VC, 0.6 wt.% Cr₃C₂ | | |
| WC²: undoped | | |
| WC³: doped with 0.4 wt.% VC, 0.6 wt.% Cr₃C₂ | | |
| WC⁴: undoped | | |

In all of the following examples the raw materials were wet ground in an attrition mill or a ball mill for 12 hours and subsequently spray dried. The ground and spray dried powder blends were then pressed to form green compacts of tools having the respective geometry as indicated. The green compacts were sintered at a temperature of approximately 1420°C for 60 min.; all sintered cemented carbides attained a porosity of <A02. After allowing the shaped sintered cemented carbide bodies to cool to room temperature, the high temperature properties of the sintered cemented carbides obtained were determined with the aid of conventional high temperature hardness tests (metal cutting tests).

Furthermore, the Vickers hardness (HV30), the coercive force and the bending strength of the cemented carbide grades in accordance with the invention and those of a few known cemented carbide grades were determined and compared with each other. Table 1 below specifies the compositions of the analyzed cemented carbide grades with the physical and mechanical properties measured in each case.

**Table 1**

| Powder blend | WC type | Co wt% | VC wt% | Cr₃C₂ Wt% | Cr % of binder phase | Ta₂O₅ wt% | TaC wt% | NbC wt% | Hc [Oe] | hardness (HV30) | TRS [MPa] |
|---|---|---|---|---|---|---|---|---|---|---|---|
| A | 2 | 10 | | 0.5 | 4.3 | 1.5 | | | 307 | 1700 | 3710 |
| B | 2 | 10 | | 0.67 | 5.8 | 1.66 | | | 295 | 1680 | 3460 |
| C | 2 | 10 | | 0.67 | 5.8 | | 1.33 | | 305 | 1690 | 3340 |
| D | 2 | 10 | | 1 | 8.7 | 1 | | | 303 | 1690 | 3600 |
| E | 2 | 10 | | 1.33 | 11.5 | 0.67 | | | 311 | 1710 | 3460 |
| F^{xx} | 2 | 10 | | 1.5 | 13 | 0.5 | | | 306 | 1700 | 2610 |
| G^{xx} | 2 | 10 | | 1.7 | 14.7 | 1.2 | | | 356 | 1760 | 2640 |
| H | 2 | 10 | | 2.3 | 19.9 | 2.4 | | | 361 | 1760 | 3350 |
| I^{x} | 1 | 10 | 0.36 | 0.54 | 4.7 | | | | 360 | 1700 | 3820 |
| J | 1 | 10 | 0.36 | 0.54 | 4.7 | 1.2 | | | 440 | 1780 | 2980 |
| K | 1 | 10 | 0.36 | 0.54 | 4.7 | | 1 | | 440 | 1780 | 2830 |
| L | 1 | 10 | 0.36 | 0.54 | 4.7 | | 0.7 | 0.3 | 461 | 1800 | 2920 |
| M | 1 | 10 | 0.36 | 0.54 | 4.7 | 3 | | | 430 | 1780 | 3120 |
| N | 1 | 10 | 0.36 | 1.2 | 10.4 | 1.2 | | | 470 | 1860 | 2840 |
| O^{xx} | 1 | 10 | 0.36 | 1.7 | 14.7 | 1.2 | | | 434 | 1820 | 1880 |
| P | 1 | 10 | 0.36 | 2.3 | 19.9 | 1.2 | | | 446 | 1840 | 2420 |
| Q^{x} | 1 | 12.5 | 0.35 | 0.53 | 3.6 | | | | 280 | 1540 | 4290 |
| R | 1 | 12.5 | 0.35 | 0.53 | 3.6 | 1.2 | | | 336 | 1620 | 3320 |
| S | 2 | 10¹ | | 1.2 | 10.4 | 1.2 | | | 292 | 1690 | 2910 |
| T^{xx} | 2 | 10¹ | | 1.7 | 14.7 | 1.2 | | | 320 | 1740 | 2260 |
| U | 2 | 10¹ | | 2.3 | 19.9 | 1.2 | | | 309 | 1700 | 2970 |
| V^{x} | 1 | 9.5 | 0.36 | 0.54 | 5.5 | | | | 385 | 1760 | 3600 |
| W | 1 | 9.5 | 0.36 | 0.54 | 5.5 | 3 | | | 444 | 1830 | 2990 |
| X^{x} | 3 | 9.5 | 0.36 | 0.54 | 5.5 | | | | 352 | 1700 | --- |
| Y | 4 | 9.5 | 0.36 | 0.54 | 5.5 | 3 | | | 293 | 1680 | --- |

| | | | | | | | | | | | |
|---|---|---|---|---|---|---|---|---|---|---|---|
| x) prior art; xx) not in accordance with the invention 1) CoNiFe binder with 60 % Co, 20 % Ni and 20 % Fe HV = Vickers hardness Hc = coercive force TRS = bending strength wt% = %, as related to the total mass | | | | | | | | | | | |

### Example 1

Cutting inserts of the SPGN 120308F geometry were made from the X and Y powder blends and were subjected to a metal cutting test under the following conditions:
Material of the workpiece to be cut: C45 steel
Cutting speed: 100 m/min.
Feed rate: 0.15 mm/revolution
Depth of cut: 1.0 mm
Coolant: none
Result: The tool life of the cutting insert made from the X powder blend (prior art) amounted to 6.4 min. until a maximum possible wear of the flank face of 0.25 mm was reached, whereas the tool life of the cutting insert according to the invention made from the Y powder blend amounted to 9.6 min., which corresponds to a 50 % increase.

Further cutting inserts of the SPGN120308F geometry, made from the X and Y powder blends, were subjected to a high temperature hardness test under the following cutting conditions:
Material of the workpiece: 50 CrV4 chrome vanadium steel
Cutting speed increasing from 80 to 120 m/min. in increments of 10 m/min. each
Cutting duration: 30 sec. each, for each cutting speed
Feed rate: 0.3 mm/revolution
Depth of cut: 2.0 mm

| Coolant: none | wear of flank face [mm] | |
|---|---|---|
| cutting speed [m/min.] | material X (prior art) | material Y |
| 80 | 0.15 | 0.12 |
| 90 | 0.24 | 0.16 |
| 100 | 0.34 | 0.21 |
| 110 | not reached | 0.27 |
| 120 | not reached | 0.32 |

Since tool temperatures rise as the cutting speed increases, the foregoing results immediately show that the known cutting inserts failed when a cutting speed of 100 m/min. was exceeded, whereas the cutting inserts manufactured from the sintered cemented carbide in accordance with the invention could be employed even at cutting speeds of up to 120 m/min. and still exhibited less wear even at such high cutting speeds than the cutting inserts made from the known cemented carbide at lower cutting speeds. The results of these metal cutting and high temperature hardness tests mean that the high temperature properties of the sintered cemented carbide in accordance with the invention are significantly better than those of the known sintered cemented carbide.

The difference between the cemented carbide grades X and Y compared with each other is the tantalum content of the grade in accordance with the invention (cf. Table 1), and hence the composition of the binder phase and the additional TaC phase visible by optical microscopy which is present only in the sintered cemented carbide grade in accordance with the invention.

### Example 2

Drills were manufactured from the V and W powder blends, only W leading to a sintered cemented carbide in accordance with the invention. The drills had a diameter of 8.5 mm, met the DIN 6537K standard [German Institute for Standardization] and were of the SE-B221 type. They had a PVD coating of TiN.

These drills were used for drilling under the following conditions:
Material of the workpiece: 42CrMo4V type chrome molybdenum steel
Cutting speed: 75 m/min.
Feed rate: 0.21 mm/revolution
Depth of hole: 30 mm
Use of an external coolant: yes
Results: The drills made from the sintered cemented carbide in accordance with the invention (material W) could be used to drill 2088 holes up to a wear of 0.15 mm.

Only 522 holes could be drilled using the conventional drills made from the material V, whereafter the cutting edge already featured chipped portions. This means an improvement of tool life by 1566 drilled holes, or 300 %, which could be attained using the drills made from the sintered cemented carbide in accordance with the invention as compared with the prior art material.

### Example 3

Ball nose endmills having a diameter of 6 mm and each having a pair of cutting edges were manufactured from the I, J and M powder blends; the endmills had a PVD coating of TiAlN. They were used for working under the following conditions:
Workpiece material: No. 1.2379 steel, hardened up to a Rockwell C hardness of 55

### Cutting speeds:

120 m/min. up to a milling length of 32 m
160 m/min. at a milling length of from 32 to 64 m
200 m/min. at a milling length of from 64 to 118 m
Feed rate per cutting edge: 0.12 mm
Depth of cut: 0.10 mm
Width of cut: 0.10 mm
Coolant: none

| Results: | wear of flank face [mm] after: | | |
|---|---|---|---|
| | 32 m | 64 m | 118 m |
| Material I (prior art) | 0.07 | 0.08 | 0.13 |
| Material J | 0.03 | 0.05 | 0.07 |
| Material M | 0.06 | 0.09 | 0.10 |

These values also reveal a distinct improvement in the high temperature properties of the milling tools manufactured from the sintered cemented carbide in accordance with the invention in comparison with the conventional tools manufactured from material I.

### Example 4

Ball nose endmills each having a pair of cutting edges, a diameter of 6 mm and a PVD coating of TiAlN were manufactured from the J, K and H powder blends. These endmills were tested under the following conditions:
Workpiece material: No. 1.2379 steel, hardened up to a Rockwell.C hardness of 55
Cutting speed: 160 m/min.
Feed rate per cutting edge: 0.10 mm
Depth of cut: 0.30 mm
Width of cut: 0.30 mm
Coolant: none

### Results:

| | wear of flank face [mm] after: | | |
|---|---|---|---|
| | 14 m | 57 m | 100 m |
| Material J | 0.04 | 0.07 | 0.11 |
| material K | 0.04 | 0.06 | 0.12 |
| material H | 0.04 | 0.07 | 0.10 |

### Example 5

Ball nose endmills having a pair of cutting edges each and a diameter of 6 mm were manufactured from the I, J and M powder blends; the endmills had a PVD coating of TiAlN. These endmills were tested under the following conditions:
Workpiece material: No. 1.2379 steel, hardened up to a Rockwell C hardness of 62
Cutting speed: 70 m/min.
Feed rate per cutting edge: 0.12 mm
Depth of cut: 0.10 mm
Width of cut: 0.10 mm
Coolant: none

### Results:

| | tool life [min.] maximum wear of flank face: 0.20 mm |
|---|---|
| material I (prior art) | 56 |
| material J | 80 |
| material M | 72 |

In this case, too, the tools manufactured from the sintered cemented carbide grades in accordance with the invention exhibit a significant improvement in the high temperature properties, namely, an improvement in tool life by 48 and 42 %, respectively, as compared with the tools manufactured from conventional cemented carbide (material I).

## Claims

1. A fine grained sintered cemented carbide containing chromium, consisting of a first phase based on tungsten carbide (WC) which is bound by means of a second phase of a metallic binder based on Co or CoNiFe, and of at least one additional phase comprising at least one carbide or mixed carbide of tantalum,
wherein
- the sintered cemented carbide contains 0.3 to 4 % Ta, as related to the total mass of the sintered cemented carbide,
- the WC has a grain size of between 0.1 and 1.3 µm,
- the binder phase forms 3 to 18 % of the total mass of the sintered cemented carbide and contains the metals W, Cr and Ta, and optionally V and/or Nb, dissolved in solid solution, the metals dissolved in the binder phase, with the exception of W, being dissolved in the binder phase in an amount corresponding to their respective solubility in the binder phase at room temperature;
- the at least one additional phase comprises a TaC phase visible by optical microscopy at 200 times magnification,
and wherein (i) the sintered cemented carbide contains 17 to 30 % Cr, as related to the total mass of the binder phase and the at least one additional phase comprises a (Cr, Co)-rich mixed carbide phase, or (ii) the sintered cemented carbide contains 1 to 12 % Cr, as related to the total mass of the binder phase.

2. The sintered cemented carbide as claimed in claim 1, **characterized in that** the WC has a grain size of between 0.3 and 0.6 µm.

3. The sintered cemented carbide as claimed in claim 1 or 2, **characterized in that** it contains 0.8 to 1.2 % Ta.

4. The sintered cemented carbide as claimed in any of claims 1 to 3, **characterized in that** up to 3 mass-% of the tungsten carbide are replaced by at least one hard component which is selected from the carbides, nitrides, carbonitrides, including their mixtures and solid solutions, of the metals Ti, Zr, Hf and Mo.

5. The sintered cemented carbide as claimed in any of claims 1 to 4, **characterized in that** up to 50 mass-% of the tantalum are replaced by niobium.

6. The sintered cemented carbide as claimed in claim 5, **characterized in that** it contains 0.4 to 0.6 % Nb, as related to the total mass of the sintered cemented carbide.

7. The sintered cemented carbide as claimed in claim 5 or 6, **characterized in that** the binder phase additionally contains Nb, dissolved in solid solution.

8. The sintered cemented carbide as claimed in any of claims 5 to 7, **characterized in that** the at least one additional phase comprises a (Ta, Nb)C phase visible by optical microscopy.

9. The sintered cemented carbide as claimed in any one of claims 1 to 8, **characterized in that** the binder phase contains up to 20 % W, as related to its mass and dissolved in solid solution.

10. The sintered cemented carbide as claimed in any of claims 1 to 9, **characterized in that** it additionally contains up to 8 % V, as related to the total mass of the binder phase.

11. The sintered cemented carbide as claimed in claim 10, **characterized in that** the binder phase contains at least 2 % V.

12. The sintered cemented carbide as claimed in claim 10 or 11, **characterized in that** the binder phase additionally contains V, dissolved in solid solution.

13. The sintered cemented carbide as claimed in any of claims 10 to 12, **characterized in that** the at least one additional phase is visible by optical microscopy and comprises at least one of the (Ta, V)C and (Ta, Nb, V)C phases.

14. The sintered cemented carbide as claimed in any of claims 1 to 13, **characterized by** a porosity of < A02.

15. The sintered cemented carbide as claimed in any of claims 1 to 14, **characterized by** a hard, wear-resistant coating applied by physical or chemical vapor deposition.

16. A cutting tool comprising a rake face and a flank face and comprising a cutting edge at the intersection of the rake face and the flank face, said cutting tool consisting of a sintered cemented carbide as claimed in any of claims 1 to 15.

17. The cutting tool as claimed in claim 16, **characterized in that** it is one of a drill, a bit, a milling cutter, a part of such tools, a cutting insert and an indexable insert.

18. A process for manufacturing the sintered cemented carbide as claimed in any of claims 1 to 15, preferably in the form of a three-dimensional body, in which fine, powdery starting materials including WC as a main constituent, Co or CoNiFe as a binder in an amount of 3 to 18 % of the total mass of the sintered cemented carbide and compounds of Cr and Ta as well as, optionally, V and/or Nb, are ground in a ball mill or in an attrition mill with the addition of carbon or tungsten and conventional grinding and/or sintering aids, compressed to form a green compact of the desired shape, and subsequently sintered and, optionally, provided with a hard, wear-resistant coating, **characterized in that** only submicron and ultrafine tungsten carbide grades having grain sizes of between 0.1 and 0.8 µm are used, and that Cr and Ta and, optionally, V and/or Nb are added to the powder blend in amounts so as to exceed the solubility of these metals in the binder phase at room temperature, and wherein chromium is added to the starting powder blend in the form of Cr₃C₂ in an amount corresponding to either 1 to 12 % or 17 to 30 % of the total mass of the metallic binder

19. The process as claimed in claim 18, **characterized in that** 0.3 to 4 % Ta, as related to the total mass of the sintered cemented carbide, are added to the powder blend, up to 50 mass-% of the tantalum being replaced by niobium, where required.

20. The process as claimed in claim 18 or 19, **characterized in that** Cr, Ta and, optionally, V and/or Nb are added to the starting powder blend individually or in solid solution in the form of carbides and/or oxides.

21. The process as claimed in any of claims 18 to 20, **characterized by** the use of WC grades which are doped with Cr₃C₂ and/or VC.

22. The process as claimed in claim 21, **characterized by** the use of WC grades which contain up to 0.6 wt.% Cr₃C₂ and/or up to 0.4 wt.% VC.

## Patentansprüche

1. Feinkörniges zementiertes Sintercarbid mit Chrom, bestehend aus einer ersten Phase basierend auf Wolframcarbid (WC), die durch eine zweite Phase eines metallischen Bindemittels basierend auf Co oder CoNiFe gebunden ist, und mindestens einer zusätzlichen Phase mit mindestens einem Carbid oder Mischcarbid von Tantal, wobei
- das zementierte Sintercarbid 0,3 bis 4 % Ta bezogen auf die Gesamtmasse des zementierten Sintercarbids enthält,
- das WC eine Korngröße von 0,1 bis 1,3 µm aufweist,
- die Bindemittelphase 3 bis 18 % der Gesamtmasse des zementierten Sintercarbids bildet und die Metalle W, Cr und Ta und gegebenenfalls V und/oder Nb aufgelöst in einer festen Lösung enthält, wobei die Metalle, die in der Bindemittelphase aufgelöst sind, mit Ausnahme von W in einer Menge in der Bindemittelphase aufgelöst sind, die ihrer jeweiligen Löslichkeit in der Biridemittelphase bei Raumtemperatur entspricht;
- die mindestens eine zusätzliche Phase eine TaC-Phase umfasst, die durch optische Mikroskopie bei 200-facher Vergrößerung sichtbar ist,
und wobei (i) das zementierte Sintercarbid 17 bis 30 % Cr bezogen auf die Gesamtmasse der Bindemittelphase enthält, und die mindestens eine zusätzliche Phase eine (Cr, Co)-reiche Mischcarbidphase umfasst, oder (ii) das zementierte Sintercarbid 1 bis 12 % Cr bezogen auf die Gesamtmasse der Bindemittelphase enthält.

2. Zementiertes Sintercarbid nach Anspruch 1, **dadurch gekennzeichnet, dass** das WC eine Korngröße von 0,3 bis 0,6 µm aufweist.

3. Zementiertes Sintercarbid nach Anspruch 1 oder 2, **dadurch gekennzeichnet, dass** es 0,8 bis 1,2 % Ta enthält.

4. Zementiertes Sintercarbid nach einem der Ansprüche 1 bis 3, **dadurch gekennzeichnet, dass** bis zu 3 Masse-% des Wolframcarbids durch mindestens eine harte Komponente ersetzt sind, die aus den Carbiden, Nitriden, Carbonitriden, einschließlich ihrer Mischungen und festen Lösungen, der Metalle Ti, Zr, Hf und Mo ausgewählt ist.

5. Zementiertes Sintercarbid nach einem der Ansprüche 1 bis 4, **dadurch gekennzeichnet, dass** bis zu 50 Masse-% des Tantals durch Niob ersetzt sind.

6. Zementiertes Sintercarbid nach Anspruch 5, **dadurch gekennzeichnet, dass** es 0,4 bis 0,6 % Nb bezogen auf die Gesamtmasse des zementierten Sintercarbids enthält.

7. Zementiertes Sintercarbid nach Anspruch 5 oder 6, **dadurch gekennzeichnet, dass** die Bindemittelphase zusätzlich Nb aufgelöst in fester Lösung enthält.

8. Zementiertes Sintercarbid nach einem der Ansprüche 5 bis 7, **dadurch gekennzeichnet, dass** die mindestens eine zusätzliche Phase eine durch optische Mikroskopie sichtbare (Ta, Nb)C-Phase umfasst.

9. Zementiertes Sintercarbid nach einem der Ansprüche 1 bis 8, **dadurch gekennzeichnet, dass** die Bindemittelphase bis zu 20 % W bezogen auf ihre Masse und aufgelöst in fester Lösung enthält.

10. Zementiertes Sintercarbid nach einem der Ansprüche 1 bis 9, **dadurch gekennzeichnet, dass** es zusätzlich bis zu 8 % V bezogen auf die Gesamtmasse der Bindemittelphase enthält.

11. Zementiertes Sintercarbid nach Anspruch 10, **dadurch gekennzeichnet, dass** die Bindemittelphase mindestens 2 % V enthält.

12. Zementiertes Sintercarbid nach Anspruch 10 oder 11, **dadurch gekennzeichnet, dass** die Bindemittelphase zusätzlich V aufgelöst in fester Lösung enthält.

13. Zementiertes Sintercarbid nach einem der Ansprüche 10 bis 12, **dadurch gekennzeichnet, dass** die mindestens eine zusätzliche Phase durch optische Mikroskopie sichtbar ist und mindestens eine der (Ta, V)C- und (Ta, Nb, V)C-Phasen umfasst.

14. Zementiertes Sintercarbid nach einem der Ansprüche 1 bis 13, gekennzeichnet durch eine Porosität von < A02.

15. Zementiertes Sintercarbid nach einem der Ansprüche 1 bis 14, gekennzeichnet durch eine harte, verschleißfeste Beschichtung, die durch physikalische oder chemische Dampfabscheidung aufgebracht ist.

16. Schneidwerkzeug, umfassend eine Abstreiffläche und eine Flankenfläche und umfassend eine Schneidkante an der Grenzfläche der Abstreiffläche und der Flankenfläche, wobei das Schneidwerkzeug aus einem zementierten Sintercarbid nach einem der Ansprüche 1 bis 15 besteht.

17. Schneidwerkzeug nach Anspruch 16, **dadurch gekennzeichnet, dass** es eines von einem Bohrer, einem Bohreinsatz, einem Fräser, einem Teil solcher Werkzeuge, einem Schneideinsatz und einem indizierbaren Einsatz ist.

18. Prozess zur Herstellung des zementierten Sintercarbids nach einem der Ansprüche 1 bis 15 vorzugsweise in Form eines dreidimensionalen Körpers, wobei feine pulverförmige Ausgangsmaterialien, die WC als einen Hauptbestandteil, Co oder CoNiFe als ein Bindemittel in einer Menge von 3 bis 18 % der Gesamtmasse des zementierten Sintercarbids und Verbindungen von Cr und Ta sowie gegebenenfalls V und/oder Nb umfassen, in einer Kugelmühle oder in einer Reibmühle unter Zugabe von Kohlenstoff oder Wolfram und herkömmlichen Mahl- und/oder Sinterhilfsmitteln gemahlen, komprimiert, um einen grünen Pressling der gewünschten Form zu bilden, und anschließend gesintert und gegebenenfalls mit einer harten, verschleißfesten Beschichtung versehen werden, **dadurch gekennzeichnet, dass** nur ultrafeine Wolframcarbidklassen im Submikrometerbereich mit Korngrößen von 0,1 bis 0,8 µm verwendet werden, und dass Cr und Ta und gegebenenfalls V und/oder Nb in solchen Mengen zum Pulvergemisch zugegeben werden, dass die Löslichkeit dieser Metalle in der Bindemittelphase bei Raumtemperatur überschritten wird, und wobei Chrom in der Form von Cr3C2 in einer Menge zum Ausgangspulvergemisch zugegeben wird, die entweder 1 bis 12 % oder 17 bis 30 % der Gesamtmasse des metallischen Bindemittels entspricht.

19. Prozess nach Anspruch 18, **dadurch gekennzeichnet, dass** 0,3 bis 4 % Ta bezogen auf die Gesamtmasse des zementierten Sintercarbids zum Pulvergemisch zugegeben werden, wobei bis zu 50 Masse-% des Tantals durch Niob ersetzt werden, soweit erforderlich.

20. Prozess nach Anspruch 18 oder 19, **dadurch gekennzeichnet, dass** Cr, Ta und gegebenenfalls V und/oder Nb einzeln oder in fester Lösung in der Form von Carbiden und/oder Oxiden zum Ausgangspulvergemisch zugegeben werden.

21. Prozess nach einem der Ansprüche 18 bis 20, gekennzeichnet durch die Verwendung von WC-Klassen, die mit Cr3C2 und/oder VC dotiert sind.

22. Prozess nach Anspruch 21, gekennzeichnet durch die Verwendung von WC-Klassen, die bis zu 0,6 Gew.-% Cr3C2 und/oder bis zu 0,4 Gew.-% VC enthalten.

## Revendications

1. Carbure cémenté fritté à grains fins contenant du chrome, constitué d'une première phase basée sur du carbure de tungstène (WC) qui est liée au moyen d'une deuxième phase d'un liant métallique basé sur Co ou CoNiFe, et d'au moins une phase supplémentaire comprenant au moins un carbure ou carbure mixte de tantale, dans lequel
- le carbure cémenté fritté contient 0,3 à 4 % de Ta, tel que rapporté à la masse totale du carbure cémenté fritté,
- le WC a une grosseur de grain comprise entre 0,1 et 1,3 µm,
- la phase de liant constitue 3 à 18 % de la masse totale du carbure cémenté fritté et contient les métaux W, Cr et Ta, et éventuellement V et/ou Nb, dissous en solution solide, les métaux dissous dans la phase de liant, à l'exception de W, étant dissous dans la phase de liant dans une quantité correspondant à leur solubilité respective dans la phase de liant à température ambiante,
- l'au moins une phase supplémentaire comprend une phase TaC visible par microscopie optique à un grossissement de 200 fois,
et dans lequel (i) le carbure cémenté fritté contient 17 à 30 % de Cr, tel que rapporté à la masse totale de la phase de liant et l'au moins une phase supplémentaire comprend une phase carbure mixte riche en (Cr, Co), ou (ii) le carbure cémenté fritté contient 1 à 12 % de Cr, tel que rapporté à la masse totale de la phase de liant.

2. Carbure cémenté fritté selon la revendication 1, **caractérisé en ce que** le WC a une grosseur de grain comprise entre 0,3 et 0,6 µm.

3. Carbure cémenté fritté selon la revendication 1 ou 2, **caractérisé en ce qu'**il contient 0,8 à 1,2 % de Ta.

4. Carbure cémenté fritté selon l'une quelconque des revendications 1 à 3, **caractérisé en ce que** jusqu'à 3 % en masse du carbure de tungstène est remplacé par au moins un composant dur qui est choisi parmi les carbures, les nitrures, les carbonitrures, y compris leurs mélanges et solutions solides, des métaux Ti, Zr, Hf et Mo.

5. Carbure cémenté fritté selon l'une quelconque des revendications 1 à 4, **caractérisé en ce que** jusqu'à 50 % en masse du tantale est remplacé par du niobium.

6. Carbure cémenté fritté selon la revendication 5, **caractérisé en ce qu'**il contient 0,4 à 0,6 % de Nb, tel que rapporté à la masse totale du carbure cémenté fritté.

7. Carbure cémenté fritté selon la revendication 5 ou 6, **caractérisé en ce que** la phase de liant contient en outre du Nb, dissous en solution solide.

8. Carbure cémenté fritté selon l'une quelconque des revendications 5 à 7, **caractérisé en ce que** l'au moins une phase supplémentaire comprend une phase (Ta, Nb)C visible par microscopie optique.

9. Carbure cémenté fritté selon l'une quelconque des revendications 1 à 8, **caractérisé en ce que** la phase de liant contient jusqu'à 20 % de W, tel que rapporté à sa masse et dissous en solution solide.

10. Carbure cémenté fritté selon l'une quelconque des revendications 1 à 9, **caractérisé en ce qu'**il contient en outre jusqu'à 8 % de V, tel que rapporté à la masse totale de la phase de liant.

11. Carbure cémenté fritté selon la revendication 10, **caractérisé en ce que** la phase de liant contient au moins 2 % de V.

12. Carbure cémenté fritté selon la revendication 10 ou 11, **caractérisé en ce que** la phase de liant contient en outre du V, dissous en solution solide.

13. Carbure cémenté fritté selon l'une quelconque des revendications 10 à 12, **caractérisé en ce que** l'au moins une phase supplémentaire est visible par microscopie optique et comprend au moins une des phases (Ta, V)C et (Ta, Nb, V)C.

14. Carbure cémenté fritté selon l'une quelconque des revendications 1 à 13, **caractérisé par** une porosité < A02.

15. Carbure cémenté fritté selon l'une quelconque des revendications 1 à 14, **caractérisé par** un revêtement dur, résistant à l'usure appliqué par dépôt physique ou chimique en phase vapeur.

16. Outil de coupe comprenant une face de coupe et une face de dépouille et comprenant une arête de coupe à l'intersection de la face de coupe et de la face de dépouille, ledit outil de coupe étant composé du carbure cémenté fritté selon l'une quelconque des revendications 1 à 15.

17. Outil de coupe selon la revendication 16, **caractérisé en ce qu'**il s'agit d'un élément parmi un foret, une mèche, une fraise, une partie de tels outils, un insert de coupe et un insert indexable.

18. Procédé de fabrication du carbure cémenté fritté selon l'une quelconque des revendications 1 à 15, de préférence sous la forme d'un corps tridimensionnel, dans lequel des matières premières en poudre fine, y compris WC en tant que principal constituant, Co ou CoNiFe en tant que liant dans une quantité de 3 à 18 % de la masse totale du carbure cémenté fritté et des composés de Cr et Ta ainsi que, éventuellement, V et/ou Nb, sont broyés dans un broyeur à boulets ou dans un broyeur à attrition avec l'addition de carbone ou de tungstène et d'adjuvants de broyage et/ou de frittage conventionnels, comprimés pour former un comprimé cru de la forme souhaitée, et ensuite frittés, et éventuellement pourvus d'un revêtement dur, résistant à l'usure, **caractérisé en ce que** seules des qualités de carbure de tungstène submicrométriques et ultrafines ayant des grosseurs de grain comprises entre 0,1 et 0,8 µm sont utilisées, et **en ce que** Cr et Ta, et éventuellement V et/ou Nb sont ajoutés au mélange de poudres dans des quantités permettant de dépasser la solubilité de ces métaux dans la phase de liant à température ambiante, et dans lequel le chrome est ajouté au mélange de poudres de départ sous la forme de Cr₃C₂ dans une quantité correspondant à 1 à 12 % ou 17 à 30 % de la masse totale du liant métallique.

19. Procédé selon la revendication 18, **caractérisé en ce que** 0,3 à 4 % de Ta, tel que rapporté à la masse totale du carbure cémenté fritté, sont ajoutés au mélange de poudres, jusqu'à 50 % en masse du tantale étant remplacé par du niobium, si nécessaire.

20. Procédé selon la revendication 18 ou 19, **caractérisé en ce que** Cr, Ta, et éventuellement V et/ou Nb sont ajoutés au mélange de poudres de départ individuellement ou en solution solide sous la forme de carbures et/ou d'oxydes.

21. Procédé selon l'une quelconque des revendications 18 à 20, **caractérisé par** l'utilisation de qualités de WC qui sont dopées avec Cr₃C₂ et/ou VC.

22. Procédé selon la revendication 21, **caractérisé par** l'utilisation de qualités de WC qui contiennent jusqu'à 0,6 % en poids de Cr₃C₂ et/ou jusqu'à 0,4 % en poids de VC.
